# EUROPEAN PATENT APPLICATION

(11) **EP 4 606 261 A1**
(43) Date of publication of application: **27.08.2025**
(21) Application number: 25153537.3
(22) Date of filing: 23.01.2025
(51) Int. Cl.: A45F 5/00, G06F 1/16

(54) **MOUNTING STRUCTURE AND PORTABLE ELECTRONIC DEVICE**

(30) Priority: 23.02.2024 CN 202410200222
(71) Applicant: Getac Technology Corporation, New Taipei City 221009 (TW)
(72) Inventor: LU, Weisen, Taipei City (TW); LEE, Chun-Hsing, 11568 Taipei (TW); CHUNG, Chia-Lung, 11568 Taipei (TW)
(74) Representative: Müller Schupfner & Partner Patent- und Rechtsanwaltspartnerschaft mbB (Muc)

(57) **Abstract**

A mounting structure is configured to be disposed on a device body, and the mounting structure includes a structure body. The structure body has a first outer surface and a second outer surface. The first outer surface and the second outer surface are not coplanar. The structure body has a through slot. The through slot penetrates through the first outer surface and the second outer surface.

## Description

### CROSS-REFERENCE TO RELATED APPLICATIONS

### Technical Field

The present disclosure relates to a mounting structure, more particularly to a mounting structure disposed on a portable electronic device.

### Background

Portable electronic devices, such as smartphones, tablet computers or notebook computers, have become indispensable electronic products in daily life since the portable electronic devices are easy to carry so that users can do various tasks matters via the portable electronic devices anytime and anywhere.

Generally, straps are provided on the portable electronic devices, so that the portable electronic devices can be easily held by the users. However, the straps are usually disposed on mounting structures located at the back of the portable electronic devices, so that the portable electronic devices cannot be placed firmly. In addition, the mounting structures are fixed on the portable electronic devices, which causes the inconvenience of the maintenance and the replacement of the straps. Therefore, how to improve the convenience of the maintenance and the replacement of the straps is one of the problems required to be addressed.

### SUMMARY

The present disclosure provides a mounting structure and a portable electronic device, so as to improve a convenience of installing/removing the strap on/from the portable electronic device.

One embodiment of the present disclosure provides a mounting structure configured to be disposed on a device body. The mounting structure includes a structure body. The structure body has a first outer surface and a second outer surface. The first outer surface and the second outer surface are not coplanar. The structure body has a through slot. The through slot penetrates through the first outer surface and the second outer surface.

Another embodiment of the present disclosure provides a portable electronic device including a device body and a mounting structure according to the above embodiment. The mounting structure is disposed on a corner of the device body.

According to the mounting structure and the portable electronic device disclosed by the above embodiments, the through slot is formed on the structure body instead of the device body. In addition, the mounting structures are disposed on corners of the device body, respectively, and a strap is configured to be disposed through the through slots. Therefore, the portable electronic device can be placed firmly. In addition, the portable electronic device assembly does not require additional mounting structures (e.g., strap rings) for the installation of the strap body, thereby improving the convenience of manufacturing the portable electronic device assembly and installing the strap body on the portable electronic device. Moreover, the fasteners can be removed to release the mounting structures from the device body for enabling the mounting structures to be replaced. Accordingly, the convenience of installing/removing the strap on/from the portable electronic device can be improved.

### BRIEF DESCRIPTION OF THE DRAWINGS

The present disclosure will become more fully understood from the detailed description given hereinbelow and the accompanying drawings which are given by way of illustration only and thus are not limitative of the present disclosure and wherein:
FIG. 1 is a perspective view of a portable electronic device in accordance with a first embodiment of the present disclosure;
FIG. 2 is a perspective view of the portable electronic device in FIG. 1 from another viewing angle;
FIG. 3 is a partially enlarged exploded view of the portable electronic device in FIG. 1;
FIG. 4 is a partially enlarged cross-sectional view of the portable electronic device in FIG. 1;
FIG. 5 is another partially enlarged cross-sectional view of the portable electronic device in FIG. 1; and
FIG. 6 is a partially enlarged exploded view of a portable electronic device in accordance with a second embodiment of the present disclosure.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

In addition, the terms used in the present disclosure, such as technical and scientific terms, have its own meanings and can be comprehended by those skilled in the art, unless the terms are additionally defined in the present disclosure. That is, the terms used in the following paragraphs should be read on the meaning commonly used in the related fields and will not be overly explained, unless the terms have a specific meaning in the present disclosure.

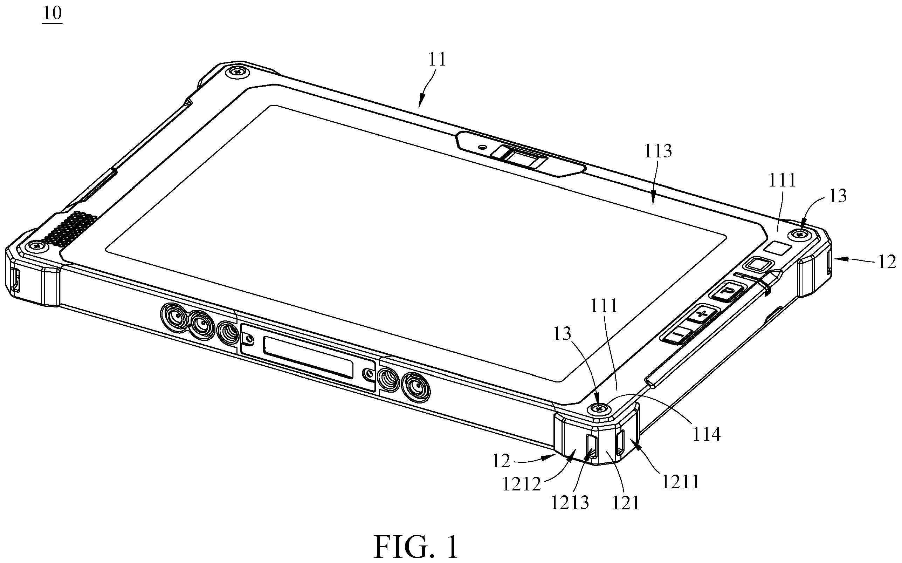

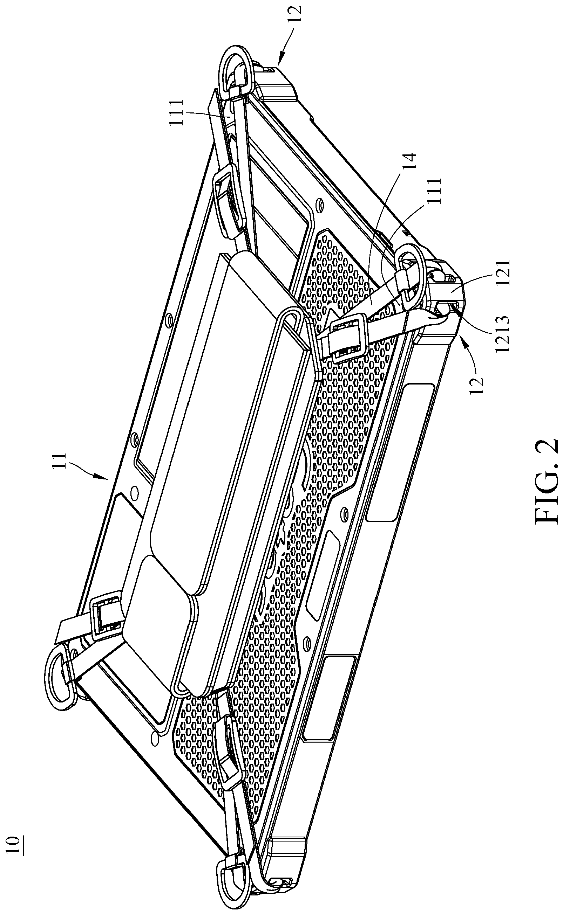

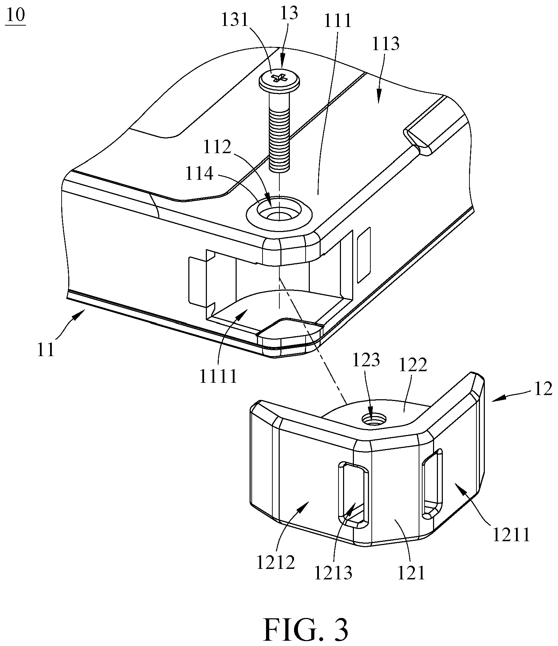

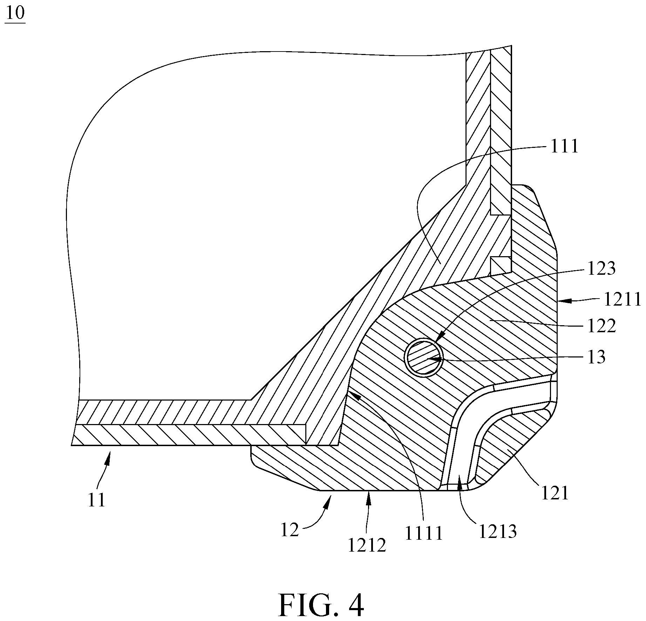

Please refer to FIG. 1 to FIG. 4, where FIG. 1 is a perspective view of a portable electronic device 10 in accordance with a first embodiment of the present disclosure, FIG. 2 is a perspective view of the portable electronic device 10 in FIG. 1 from another viewing angle, FIG. 3 is a partially enlarged exploded view of the portable electronic device 10 in FIG. 1, and FIG. 4 is a partially enlarged cross-sectional view of the portable electronic device 10 in FIG. 1.

In this embodiment, the portable electronic device 10 includes a device body 11, a plurality of mounting structures 12 and a strap 14. The mounting structure 12 is configured to mount the strap 14 on the device body 11. The device body 11 is, for example, a smartphone or a tablet computer.

The mounting structures 12 are disposed on corners 111 of the device body 11, respectively. Each of the mounting structures 12 includes a structure body 121. The structure body 121 has a first outer surface 1211 and a second outer surface 1212. The first outer surface 1211 and the second outer surface 1212 are not coplanar. The structure body 121 has a through slot 1213. In detail, the through slot 1213 penetrates through the first outer surface 1211 and the second outer surface1212 and is integrally formed on the structure body 121.

The strap 14 is disposed through the through slots 1213, so that the portable electronic device 10 can be held more conveniently via the strap 14.

In this embodiment, the through slot 1213 is integrally formed on the structure body 121 instead of the device body 11. In addition, the mounting structures 12 are disposed on the corners 111 of the device body 11, respectively, and the strap 14 is disposed through the through slots 1213. Therefore, the portable electronic device 10 is allowed to be firmly placed, and does not need to install additional assembling structures such as strap loops, so that an inconvenience of assembling and manufacturing of the portable electronic device 10 can be reduced.

In this embodiment, each of the corners 111 of the device body 11 has a limiting portion 1111. The limiting portions 1111 are, for example, recesses. Each of the mounting structures 12 further includes a restricting portion 122. The restricting portion 122 is, for example, protrusion, and is disposed on the structure body 121. The through slot 1213 penetrates through the first outer surface 1211, the restricting portion 122 and the second outer surface 1212. Each of the restricting portions 122 and each of the limiting portions 1111 are a protrusion and a recess matching each other, and contact with each other. Accordingly, the mounting structures 12 are positioned on the corners 111 of the device body 11, respectively, via the restricting portions 122 and the limiting portions 1111.

In this embodiment, the portable electronic device 10 may include a plurality of fasteners 13. The fasteners 13 are, for example, screws. The device body 11 has a plurality of second fastening holes 112. The second fastening holes 112 are, for example, screw holes. Each of the mounting structures 12 may have a first fastening hole 123. The first fastening holes 123 are, for example, screw holes, and are located on the restricting portions 122, respectively.

An extending direction of the second fastening holes 112 and an extending direction of the first fastening hole 123 are substantially perpendicular to a normal direction of an outer surface 113 of the device body 11. The outer surface 113 is, for example, a display surface of the device body 11 for displaying images. The fasteners 13 are fastened into the second fastening holes 112 and the first fastening hole 123 of the mounting structure 12. That is, the mounting structures 12 are screwed to the device body 11 via the fasteners 13 along the direction perpendicular to the normal direction of the outer surface 113 of the device body 11.

In this embodiment, the mounting structures 12 are screwed to the corners 111 of the device body 11 via the fasteners 13. Therefore, the fasteners 13 can be removed to release the mounting structures 12 from the device body 11 for enabling the mounting structures 12 to be replaced. Accordingly, a convenience of installing/removing the strap 14 on/from the portable electronic device 10 can be improved.

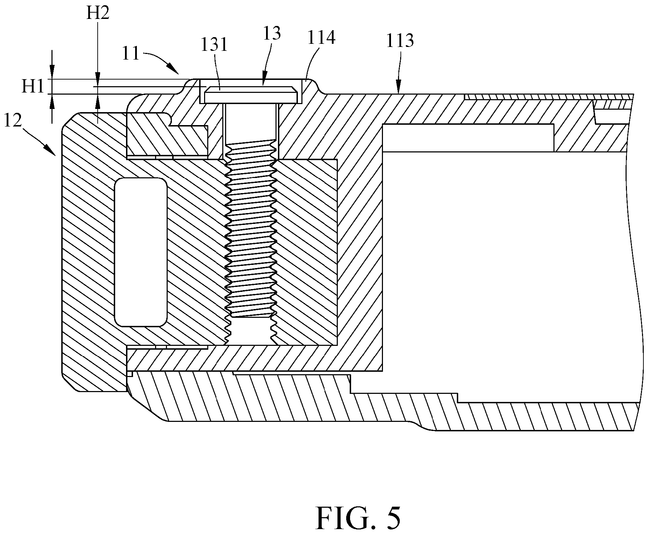

Please refer to FIG. 1 to FIG. 5, where FIG. 5 is another partially enlarged cross-sectional view of the portable electronic device 10 in FIG. 1. In this embodiment, each of the fasteners includes a head portion 131. A top surface of the head portions 131 facing away from the mounting structure 12 is located farther away from the mounting structure 12 than the outer surface 113 of the device body 11. The device body 11 includes a plurality of protruding portions 114. The protruding portions 114 are located on the corners 111, respectively, and protrude from the outer surface 113. A height H1 of each of the protruding portions 114 relative to the outer surface 113 is greater than a height H2 of each of the head portions 131 relative to the outer surface 113 (i.e., the distance between the top surface of the head portion 131 facing away from the mounting structure 12 and the outer surface 113). The protruding portions 114 surround the head portions 131, respectively. Accordingly, when the portable electronic device 10 is impacted, the display surface for displaying images of the device body 11 cannot be impacted directly due to the head portions 131 of the fasteners and the protruding portions 114 protruding from the outer surface 113. In addition, since the height H1 of each of the protruding portions 114 protruding from the outer surface 113 is greater than the height H2 of each of the head portions 131 protruding from the outer surface 113, the head portions 131 can be prevented from accidentally scratching a surrounding object, such as a table, a ground, or a wall, due to protruding from the outer surface 113.

In this embodiment, the mounting structures 12 are, for example, buffer pads, and are disposed on the corners 111 of the device body 11, respectively. Accordingly, when the portable electronic device 10 is impacted by, for example, dropping on the ground, the mounting structures 12 can absorb the impact to protect the portable electronic device 10.

In this embodiment, the portable electronic device 10 includes the plurality of mounting structures 12, but the present invention is not limited thereto. In other embodiments, the portable electronic device may include only one mounting structure. In addition, the strap may be optionally disposed through the through slots of the mounting structures according to different situations.

In this embodiment, the mounting structures 12 are screwed to the device body 11 via the fasteners 13, but the present invention is not limited thereto. In other embodiments, the mounting structures may be disposed on the device body via other fixing methods.

In this embodiment, the outer surface 113 is a display surface for displaying images of the device body 11, but the present invention is not limited thereto. In other embodiments, the outer surface may be other surface of the device body.

In this embodiment, the limiting portions 1111 are recesses, and the restricting portion 122 are protrusions, but the present invention is not limited thereto. In other embodiments, the recess and protrusion configurations of the limiting portions and the restricting portion may be exchanged. That is, the limiting portions may be protrusions, and the restricting portion may be recesses.

In the first embodiment, each of the mounting structures 12 has the first fastening hole 123. The first fastening holes 123 are located on the restricting portions 122, respectively. The extending direction of the first fastening holes 123 and the extending direction of the second fastening holes 112 are substantially perpendicular to the normal direction of an outer surface 113 of the device body 11, but the present invention is not limited thereto.

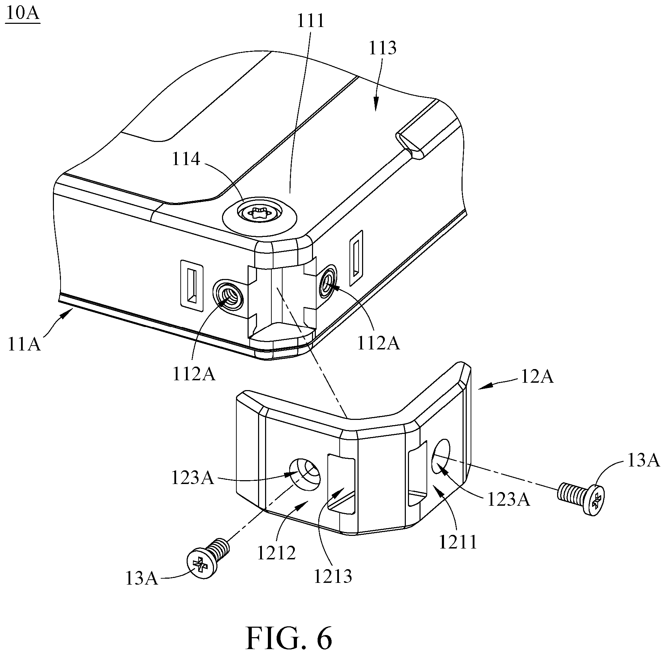

In other embodiments, please refer to FIG. 6, which is a partially enlarged exploded view of a portable electronic device 10A in accordance with a second embodiment of the present disclosure. The portable electronic device 10A of this embodiment is similar to the portable electronic device 10 of the first embodiment, the main difference between them will be described below, and the same parts between them can be referred to the aforementioned paragraphs with the reference to FIG. 1 to FIG. 5 and will not be repeatedly introduced hereinafter. In this embodiment, each of the mounting structures 12A of the portable electronic device 10A has a plurality of first fastening holes 123A. The first fastening holes 123A are located on the first outer surface 1211 and the second outer surface 1212, respectively. An extending direction of the second fastening holes 112A and an extending direction of the first fastening holes 123A are substantially parallel to a normal direction of an outer surface 113 of the device body 11A. The fasteners 13A are fastened into the second fastening holes 112 and the first fastening holes 123A of the mounting structures 12A. That is, the mounting structures 12A are screwed to the device body 11A via the fasteners 13A along the direction parallel to the normal direction of the outer surface 113 of the device body 11A.

According to the mounting structure and the portable electronic device disclosed by the above embodiments, the through slot is formed on the structure body instead of the device body. In addition, the mounting structures are disposed on corners of the device body, respectively, and a strap is configured to be disposed through the through slots. Therefore, the portable electronic device can be placed firmly. In addition, the portable electronic device assembly does not require additional mounting structures (e.g., strap rings) for the installation of the strap body, thereby improving the convenience of manufacturing the portable electronic device assembly and installing the strap body on the portable electronic device. Moreover, the fasteners can be removed to release the mounting structures from the device body for enabling the mounting structures to be replaced. Accordingly, the convenience of installing/removing the strap on/from the portable electronic device can be improved.

It will be apparent to those skilled in the art that various modifications and variations can be made to the present disclosure. It is intended that the specification and examples be considered as exemplary embodiments only, with a scope of the disclosure being indicated by the following claims and their equivalents.

## Claims

1. A mounting structure (12), configured to mount a strap (14) on a device body (11) and comprising:
a structure body (121), having a first outer surface (1211) and a second outer surface (1212), wherein the first outer surface (1211) and the second outer surface (1212) are not coplanar, the structure body (121) has a through slot (1213), and the through slot (1213) penetrates through the first outer surface (1211) and the second outer surface (1212).

2. The mounting structure according to claim 1, further comprising a restricting portion (122), wherein the restricting portion (122) is disposed on the structure body (121), and the through slot (1213) penetrates through the first outer surface (1211), the restricting portion (122) and the second outer surface (1212).

3. The mounting structure according to claim 2, further having at least one first fastening hole (123).

4. The mounting structure according to claim 3, wherein the at least one first fastening hole (123) is located on the restricting portion (122).

5. The mounting structure according to claim 3, wherein the at least one first fastening hole (123) is located on the first outer surface (1211) or the second outer surface (1212).

6. A portable electronic device (10), comprising:
a device body (11); and
a mounting structure (12) according to claim 1, disposed on a corner of the device body (11).

7. The portable electronic device according to claim 6, wherein the mounting structure (12) comprises a restricting portion (122), the restricting portion (122) is disposed on the structure body (121), and the through slot (1213) penetrates through the first outer surface (1211), the restricting portion (122) and the second outer surface (1212).

8. The portable electronic device according to claim 7, wherein the corner (111) of the device body (11) has a limiting portion (1111), the restricting portion (122) of the mounting structure (12) is limited by the limiting portion (1111), and the restricting portion (122) and the limiting portion (1111) are a protrusion and a recess matching each other.

9. The portable electronic device according to claim 7, wherein the mounting structure (12) has at least one first fastening hole (123).

10. The portable electronic device according to claim 9, further comprising at least one fastener (13), wherein the device body (11) has at least one second fastening hole (112), and the at least one fastener (13) is fastened into the at least one first fastening hole (123) of the mounting structure (12) and the at least one second fastening hole (112).

11. The portable electronic device according to claim 10, wherein the at least one first fastening hole (123) is located on the restricting portion (122).

12. The portable electronic device according to claim 10, wherein the at least one first fastening hole (123) is located on the first outer surface (1211) or the second outer surface (1212).

13. The portable electronic device according to claim 11, wherein an extending direction of the at least one first fastening hole (123) and an extending direction of the at least one second fastening hole (112) are substantially perpendicular to a normal direction of an outer surface (113) of the device body (11), the at least one fastener (13) comprises a head portion (131), and a top surface of the head portion (131) facing away from the mounting structure (12) is located farther away from the mounting structure (12) than the outer surface (113) of the device body (11)[User2].

14. The portable electronic device according to claim 12, wherein an extending direction of the at least one first fastening hole (123) and an extending direction of the at least one second fastening hole (112) are substantially parallel to a normal direction of an outer surface (113) of the device body (11).

15. The portable electronic device according to claim 6, further comprising a strap (14), wherein the strap (14) is disposed through the through slot (1213).
